(19) Europäisches Patentamt
European Patent Office
Office européen des brevets

(11) **EP 3 030 537 B1**

(12) **EUROPÄISCHE PATENTSCHRIFT**

(45) Veröffentlichungstag und Bekanntmachung des Hinweises auf die Patenterteilung:
**13.12.2017 Patentblatt 2017/50**

(21) Anmeldenummer: **14750209.0**

(22) Anmeldetag: **07.08.2014**

(51) Int Cl.:
*C04B 35/495* (2006.01)  *H01L 41/187* (2006.01)

(86) Internationale Anmeldenummer:
**PCT/EP2014/067036**

(87) Internationale Veröffentlichungsnummer:
**WO 2015/018915 (12.02.2015 Gazette 2015/06)**

(54) **PIEZOKERAMISCHER WERKSTOFF MIT REDUZIERTEM BLEIGEHALT**

PIEZOCERAMIC MATERIAL WITH REDUCED LEAD CONTENT

MATIÈRE PIÉZOCÉRAMIQUE À TENEUR EN PLOMB RÉDUITE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.08.2013 DE 102013013182**

(43) Veröffentlichungstag der Anmeldung:
**15.06.2016 Patentblatt 2016/24**

(73) Patentinhaber: **PI Ceramic GmbH**
**07589 Lederhose (DE)**

(72) Erfinder:
• **HENNIG, Eberhard**
 **07646 Mörsdorf (DE)**
• **KYNAST, Antje**
 **04275 Leipzig (DE)**
• **TÖPFER, Michael**
 **99310 Arnstadt (DE)**
• **HOFMANN, Michael**
 **07806 Neustadt an der Orla (DE)**

(74) Vertreter: **Kruspig, Volkmar**
**Meissner Bolte Patentanwälte**
**Rechtsanwälte Partnerschaft mbB**
**Widenmayerstraße 47**
**80538 München (DE)**

(56) Entgegenhaltungen:
**DE-A1-102010 041 567**

• **HENRY E. MGBEMERE ET AL: "Structural phase transitions and electrical properties of (KxNa1-x)NbO3-based ceramics modified with Mn", JOURNAL OF THE EUROPEAN CERAMIC SOCIETY, Bd. 32, Nr. 16, 1. Dezember 2012 (2012-12-01), Seiten 4341-4352, XP055141371, ISSN: 0955-2219, DOI: 10.1016/j.jeurceramsoc.2012.07.033**
• **WON AHN CHANG ET AL: "Effect of Ta content on the phase transition and piezoelectric properties of lead-free (KNaLi)(NbMnTa)Othin film", JOURNAL OF APPLIED PHYSICS, AMERICAN INSTITUTE OF PHYSICS, US, Bd. 111, Nr. 2, 15. Januar 2012 (2012-01-15), Seiten 24110-24110, XP012158003, ISSN: 0021-8979, DOI: 10.1063/1.3680882 [gefunden am 1901-01-01]**
• **JÉRÔME ACKER ET AL: "Influence of Alkaline and Niobium Excess on Sintering and Microstructure of Sodium-Potassium Niobate (K 0.5 Na 0.5 )NbO 3", JOURNAL OF THE AMERICAN CERAMIC SOCIETY, Bd. 93, Nr. 5, 1. Februar 2010 (2010-02-01), Seite 1270, XP055141373, ISSN: 0002-7820, DOI: 10.1111/j.1551-2916.2010.03578.x**
• **YASUYOSHI SAITO ET AL: "Lead-free piezoceramics", NATURE, NATURE PUBLISHING GROUP, UNITED KINGDOM, Bd. 432, Nr. 7013, 4. November 2004 (2004-11-04), Seiten 84-87, XP009161825, ISSN: 0028-0836 in der Anmeldung erwähnt**

EP 3 030 537 B1

## Beschreibung

Die Erfindung betrifft einen piezokeramischen Werkstoff mit reduziertem Bleigehalt auf Kalium-Natrium-Niobat (KNN)-Basis einer Grundzusammensetzung gemäß Oberbegriff des Anspruchs 1.

Der derzeitige Stand der Technik bei der Herstellung piezokeramischer Werkstoffe ist von einem Umbruch im Hinblick auf die angestrebte Umstellung bleifreier oder bleireduzierter Produkte gekennzeichnet. So sind in der Richtlinie 2011/65/EU (RoHS2) Maßnahmen zur Reduzierung der Verwendung besonders gefährlicher Stoffe wie Blei in Elektro- und Elektronikgeräten gefordert. Demnach unterliegen Stoffe mit bspw. einem Bleigehalt größer 0,1 Gew.-% im homogenen Material Beschränkungen und dürfen nur mit Ausnahmegenehmigungen in den Verkehr gebracht werden. Umweltfreundlichere Alternativen der Ausgangswerkstoffe müssen jedoch mindestens genauso leistungsfähig sein und ähnliche Parameter aufweisen wie bisherige bleihaltige Varianten. Derzeit ist Blei-Zirkonat-Titanat (PZT) der am meisten verwendete piezokeramische Grundwerkstoff, wenn es beispielsweise um schnellschaltbare piezoelektrische Anwendungen im Kraftfahrzeug-Bereich oder Sensoren geht.

Es wurde bereits vorgeschlagen, PZT durch Kalium-Natrium-Niobat (KNN) zu ersetzen. Insbesondere die komplexe Modifizierung der KNN Werkstoffe mit Lithium, Tantal und Antimon ("Lead-free piezoceramics",Saito u.a.; Letters to Nature, 2004) besitzt das Potential, Alternativen zum PZT darzustellen.

So beschreibt die EP1382588A1 eine bleifreie piezokeramische Zusammensetzung mit einem Hauptbestandteil der allgemeinen Formel $\{Li_x(K_{1-y}Nay)_{1-x}\} (Nb_{1-z-w}Ta_zSb_w)O_3$ und mindestens einem metallischen Element ausgewählt aus (1) Palladium, Silber, Gold, Ruthenium, Rhodium, Rhenium, Osmium, Iridium und Platin oder (2) Nickel, Eisen, Mangan, Kupfer, Zink oder (3) Magnesium, Calcium, Strontium und Barium als zusätzlichem Element.

Die DE102007013874A1 beschreibt ein mehrschichtiges piezoelektrisches Element, das eine Vielzahl von bleifreien piezoelektrischen Schichten aufweist, die ein Oxid enthalten, das ein Alkalimetallelement insbesondere in Form von Natrium, Kalium oder Lithium umfasst und Niob oder Wismut enthält.

Die EP2104152A2 beschreibt ein piezoelektrisches Element, das eine bleifreie piezoelektrische Keramik enthält. Als Hauptbestandteile der piezoelektrischen Keramik werden die Komponenten $KNbO_3$ und $BaTiO_3$ genannt. Die piezoelektrischen Keramiken weisen die allgemeine Formel $xKNbO_3$-$(1-x)BaTiO_3$ auf, wobei x zwischen 0.5 und 0.9 liegt.

Trotz intensiver Forschungen und Entwicklungen in den vergangenen 10 Jahren ist es bisher nicht gelungen, diese aussichtsreichen bleifreien Werkstoffe im industriellen Maßstab herzustellen. Als kritisches Moment hat sich dabei herausgestellt, dass die gewünschten Eigenschaften bei konventioneller Sinterung nur in einem sehr engen Sinterintervall von 10 bis 20 K erreicht werden. Zur Lösung dieses Problems werden im Stand der Technik unterschiedliche Ansätze beschrieben. Einerseits soll insbesondere das Sinterverhalten durch weitere (bleifreie) Zusätze verbessert werden.

EP1876155A1, EP1876156A1 und DE112006003755B4 zielen auf eine Verbreiterung des Sinterintervalls eines KNN-Werkstoffes auf der Basis von (K1-a-bNaaLib)m(Nb1-c-dTacSbd)O3 mit 0≤a≤0.9, 0≤ b≤ 0.3, 0≤a+b≤0.9, 0≤c≤0.5, 0≤d≤0.1, 0.7≤m≤1.3 durch Zusatz perowskitischer Oxide bzw. Oxidkomplexe und weiterer Oxide ab.

Die EP 1702906A1 beschreibt einen piezokeramischen Werkstoff, bei dem eine keramische Grundzusammensetzung durch Zugabe von beispielsweise Erdalkalimetallmetaniobat modifiziert ist.

Andererseits werden alternative Sinterverfahren wie Heißpressen, Spark Plasma Sinterung (Li u.a.; J. Am. Ceram. Soc., 96 [12] 3677-3696 (2013)) oder ein zweistufiges Sintern mit Aufheizraten von 10 K/min (Pang u.a.; Ceramics International, 38 (2012) 2521 - 2527) vorgeschlagen. Diese Verfahren sind aber für eine kostengünstige Massenfertigung nicht geeignet oder lassen sich aufgrund der thermischen Trägheit großer Sintervolumina großtechnisch nicht umsetzen.

Aus dem Vorgenannten ist es daher Aufgabe der Erfindung, einen piezokeramischen Werkstoff auf der Basis von Kalium-Natrium-Niobat (KNN) anzugeben, welcher bei reduziertem Bleigehalt eine ausreichend große Dehnung für die Anwendung im Bereich der Multilayeraktoren aufweist und der im Vergleich zu bekannten bleifreien-KNN-basierten Werkstoffen ein großtechnisch, gut handhabbares, breites Sinterintervall besitzt und daher mit konventionellen Sintermethoden verarbeitet werden kann

Die Lösung der Aufgabe der Erfindung erfolgt durch einen piezokeramischen Werkstoff gemäß der Merkmalskombination nach Anspruch 1, sowie ein Verfahren zur Herstellung eines derartigen Werkstoffs nach Anspruch 12. Erfindungsgemäß ist darüber hinaus ein piezoelektrischer Multilayeraktor auf der Basis eines erfindungsgemäßen Werkstoffs gemäß Definition nach Anspruch 13. Erfindungsgemäß ist ebenfalls eine Verwendung einer Mischung von Pb, Nb und optional Ag in einem piezokeramischen Werkstoff auf Kalium-Natrium-Niobat (KNN)-Basis zur Erhöhung des Sinterintervalls.

Es wird demnach von einem bleifreien piezokeramischen Werkstoff auf Kalium-Natrium-Niobat (KNN)-Basis der Grundzusammensetzung

$(K_xNa_yLi_{1-x-y})a (Mn_uTa_vSb_wNb_{1-u-v-w})O_3$

0<x<1 y; 0<y<1; 0<u<0,01; 0<v<0,3; 0≤w <0,2

0,95<a<1,05; x+y ≤ 1;

ausgegangen.

Erfindungsgemäß erfolgt die Zugabe einer Mischung von Pb, Nb und Ag wie folgt

k Gew.-% Pb + I Gew.-% Nb + m Gew.-% Ag

mit

$0 < k < 0,5$; $0 < l < 1$; $0 \leq m < 1$.

Dabei beziehen sich die Angaben k, I und m auf die Gew.-% der jeweiligen Komponente bezogen auf die Gesamtmasse des piezokeramischen Werkstoffs.

Der erfindungsgemäße piezokeramische Werkstoff weist somit die Grundzusammensetzung

$(K_x N_{ay} Li_{1-x-y})a (Mn_u Ta_v Sb_w Nb_{1-u-v-w})O_3$ mit

$0 < x < 1$ y; $0 < y < 1$; $0 < u < 0,01$; $0 < v < 0,3$; $0 \leq w < 0,2$ und

$0,95 < a < 1,05$; $x + y \leq 1$;

auf und ist dadurch charakterisiert, dass er zusätzlich zu der Grundzusammensetzung eine weitere Komponente enthält, die Pb, Nb und optional Ag umfasst, wobei die Gewichtsanteile von Pb, Nb und Ag bezogen auf das Gesamtgewicht des piezokeramischen Werkstoffes wie folgt gewählt sind:

k Gew.-% Pb + I Gew.-% Nb + m Gew.-% Ag

mit

$0 < k < 0,5$; $0 < l < 1$; $0 \leq m < 1$.

In einer bevorzugten Ausführungsform ist die Menge an zugesetztem Pb so gewählt, dass $0,001 < k \leq 0,2$ ist.

In einer weiteren bevorzugten Ausführungsform ist die Menge an zugesetztem Nb so gewählt, dass $0 < l \leq 0,179$ ist.

Besonders gute Ergebnisse wurden erzielt, wenn das Verhältnis von zugesetztem Pb zu zugesetztem Nb so gewählt ist, dass $0,001 < k \leq 0,2$ ist und $0 \leq l \leq 0,179$ ist.

Es hat sich gezeigt, dass besonders vorteilhafte Ergebnisse erzielt werden können, wenn die Menge an zugesetztem Pb so gewählt ist, dass $0,001 < k \leq 0,1$ ist.

Es hat sich ferner gezeigt, dass besonders gute Ergebnisse erzielt werden, wenn die Menge an zugesetztem Nb so gewählt ist, dass $0,022 < l \leq 0,09$ ist.

Besonders bevorzugt werden die Mengen an zugegebenen Pb und Nb so gewählt, dass $0,001 < k \leq 0,1$ ist und $0,022 < l \leq 0,09$ ist.

Aus den experimentellen Untersuchungen hat sich weiter ergeben, dass die Lösung der Aufgabe auch erreicht werden kann, wenn die weitere Komponente neben Pb und Nb sowie optional Ag zusätzlich Mn umfasst. Dabei werden besonders gute Ergebnisse erzielt, wenn die weitere Komponente k Gew.-% Pb, I Gew.-% Nb und n Gew.-% Mn umfasst, wobei das Verhältnis n:l im Bereich von 0,05 bis 0,15:0,30 liegt.

Als besonders bevorzugt hat es sich dabei erwiesen, dass das Verhältnis von Pb zu Mn zu Nb so gewählt ist, dass k:n:l bei 1:0,09:0,30 liegt.

Es hat sich gezeigt, dass die erfindungsgemäßen piezokeramischen Werkstoffe ein Sinterintervall im Bereich von >20 K, insbesondere im Bereich von 30 K bis 40 K aufweisen.

Der piezokeramische Werkstoff mit reduziertem Bleigehalt wird durch die Schritte der Herstellung eines Kalzinats der Grundzusammensetzung und die Zugabe der Sinterhilfsmittelmischung vollzogen. Die Zugabe der Sinterhilfsmittelmischung, die Pb, Nb und optional Ag und optional Mn umfasst, kann insbesondere bei der Feinmahlung erfolgen.

Die Weiterverarbeitung wird in bekannter Weise einschließlich Sinterung in normaler Atmosphäre realisiert.

Die Erfindung bezieht sich somit ebenso auf ein Verfahren zur Herstellung eines piezokeramischen Werkstoffs mit reduziertem Bleigehalt gekennzeichnet durch folgende Schritte:

- Herstellung einer Rohstoffmischung der Grundzusammensetzung
- Herstellung eines Kalzinats der Grundzusammensetzung
- Feinmahlung des Kalzinats
- Herstellung eines Granulats insbesondere durch Sprühgranulierung oder Herstellung eines Gießschlickers für den Multilayer- oder "Co-firing"-Prozess
- Weiterverarbeitung in bekannter Weise einschließlich Sinterung in normaler Atmosphäre.

Unter "Co-firing" Prozess ist im Sinne der vorliegenden Erfindung ein besonders innovatives Herstellungsverfahren zu verstehen, bei dem zunächst Folien aus Piezokeramikmaterial gegossen und anschließend noch im Grünzustand mit Elektroden versehen werden. Aus vielen Einzelfolien wird ein Piezoelement laminiert und anschließend gemeinsam mit den Innenelektroden in einem einzigen Prozessschritt gesintert, wie beispielsweise in der DE10234787C1 beschrieben.

Erfindungsgemäß ist ein piezokeramischer Multilayeraktor auf der Basis des piezokeramischen Werkstoffs gemäß der Lehre nach Anspruch 13.

Die Erfindung betrifft auch die Verwendung einer Mischung von Pb, Nb und optional Ag in einem piezokeramischen Werkstoff auf Kalium-Natrium-Niobat (KNN)-Basis der Grundzusammensetzung

$$(K_xNa_yLi_{1-x-y})a\ (Mn_uTa_vSb_wNb_{1-u-v-w})O_3$$

mit

$0<x<1\ y;\ 0<y<1;\ 0<u<0,01;\ 0<v<0,3;\ 0\leq w<0,2$ und
$0,95<a<1,05;\ x+y \leq 1;$

zur Erhöhung des Sinterintervalls des piezokeramischen Werkstoffs, wobei die Zugabe einer Mischung von Pb und Nb und optional Ag so erfolgt, dass der Gehalt von durch die Zugabe zugesetztem Pb, Nb und Ag in Gew.-% bezogen auf den gesamten piezokeramischen Werkstoff wie folgt ist:

$$k\ \text{Gew.-\% Pb} + l\ \text{Gew.-\% Nb} + m\ \text{Gew.-\% Ag}$$

mit

$0<k<0,5;\ 0<l<1;\ 0\leq m<1.$

In einer bevorzugten Ausführungsform ist die Menge an zugesetztem Pb so gewählt, dass $0,001<k\leq0,2$ ist.

In einer weiteren bevorzugten Ausführungsform ist die Menge an zugesetztem Nb so gewählt, dass $0<l\leq0,179$ ist.

Besonders gute Ergebnisse wurden erzielt, wenn das Verhältnis von zugesetztem Pb zu zugesetztem Nb so gewählt ist, dass $0,001<k\leq0,2$ ist und $0<l\leq0,179$ ist.

Es hat sich gezeigt, dass besonders vorteilhafte Ergebnisse erzielt werden können, wenn die Menge an zugesetztem Pb so gewählt ist, dass $0,001<k\leq0,1$ ist.

Es hat sich ferner gezeigt, dass besonders gute Ergebnisse erzielt werden, wenn die Menge an zugesetztem Nb so gewählt ist, dass $0,022<l\leq0,09$ ist.

Besonders bevorzugt werden die Mengen an zugegebenen Pb und Nb so gewählt, dass $0,001<k\leq0,1$ ist und $0,022<l\leq0,09$ ist.

Aus den experimentellen Untersuchungen hat sich weiter ergeben, dass die Lösung der Aufgabe auch erreicht werden kann, wenn die weitere Komponente neben Pb und Nb sowie optional Ag zusätzlich Mn umfasst. Dabei werden besonders gute Ergebnisse erzielt, wenn die weitere Komponente k Gew.-% Pb, l Gew.-% Nb und n Gew.-% Mn umfasst, wobei das Verhältnis n:l im Bereich von 0,05 bis 0,15:0,30 liegt.

Als besonders bevorzugt hat es sich dabei erwiesen, dass das Verhältnis von Pb zu Mn zu Nb so gewählt ist, dass k:b:l bei 1:0,09:0,30 liegt.

In überraschender Weise hat sich durch die Zugabe der Sinterhilfsmittel Pb, Nb und optional Ag und optional Mn gezeigt, dass zum einen der hohe Isolationswiderstand und das Dehnungsvermögen der Grundzusammensetzung erhalten bleibt. Zum anderen ergibt sich eine Verbreiterung des Sinterintervalls auf Bereiche zwischen 30 K und 40 K. Die Zugabe Pb und Nb kann als nominelle Verbindung in Form von Bleimetaniobat erfolgen, wobei die zugesetzte Menge des Sinterhilfsmittels so gewählt ist, dass der Bleigehalt im Bereich von 0,05 Gew.-% bis 0,2 Gew.-% liegt. Besonders bevorzugt liegt der Bleigehalt bei maximal 0,1 Gew.-%, bezogen auf den gesamten piezokeramischen Werkstoff.

Die Figuren dienen der Erläuterung der Ergebnisse der erfindungsgemäßen Untersuchungen verschiedener Materialien auf KNN-Basis.

**Fig. 1** beschreibt den allgemeinen technologischen Ablauf der Probenherstellung. Mit "*" sind diejenigen technologischen Schritte gekennzeichnet, in denen der beschriebene Zusatz von Pb und Nb und optional Ag und optional Mn erfolgen kann.

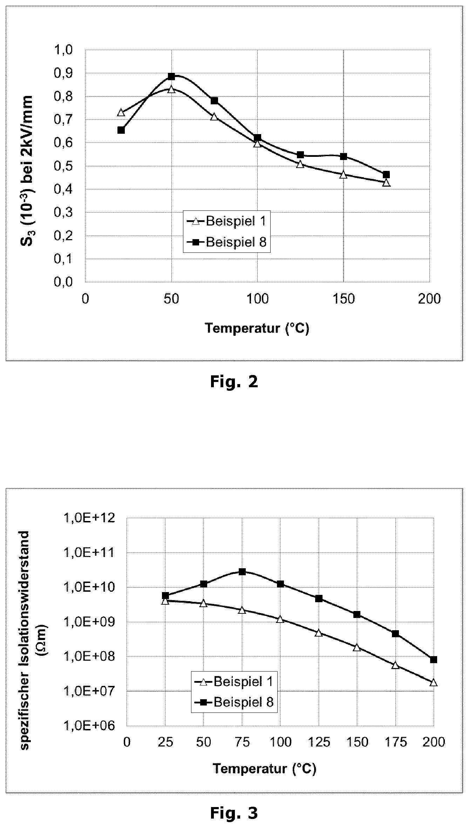

**Fig. 2** zeigt im Vergleich die typische Temperaturabhängigkeit der unipolaren Dehnung der Ausführungsbeispiele 1 (Stand der Technik) und 8 bei einer Ansteuerfeldstärke von 2 kV/mm.

**Fig. 3** zeigt im Vergleich die typische Temperaturabhängigkeit des spezifischen Isolationswiderstandes der Ausführungsbeispiele 1 (Stand der Technik) und 8.

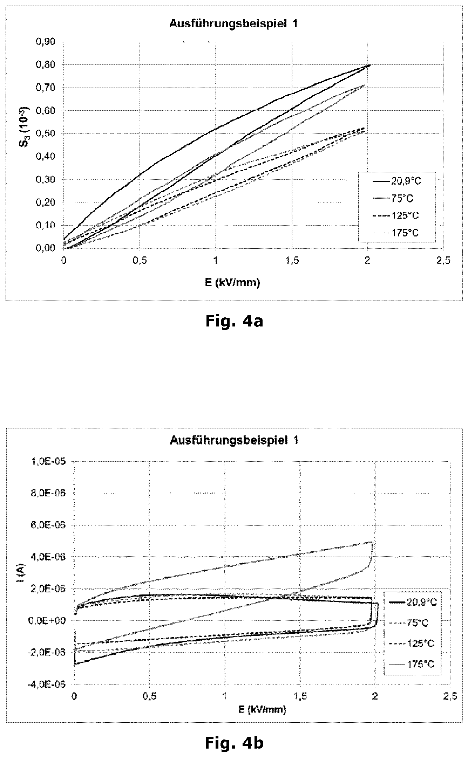

**Fig. 4a** zeigt die unipolare Dehnungshysterese und **Fig. 4b** den Probenstrom im Temperaturbereich von Raumtemperatur bis 175 °C für das Ausführungsbeispiel 1.

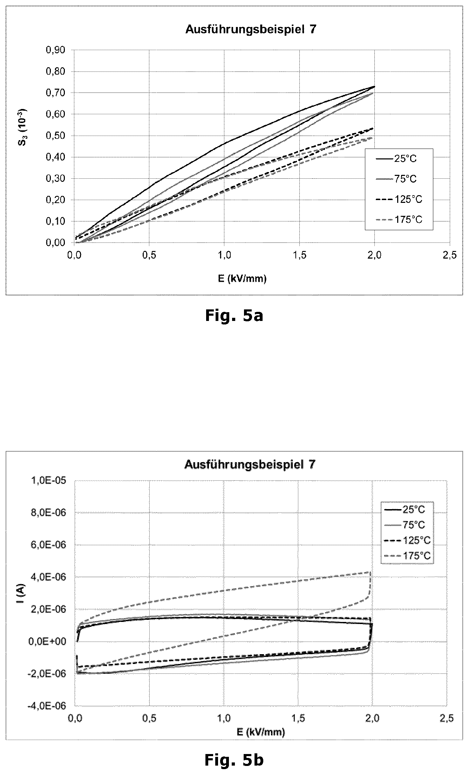

**Fig. 5a** zeigt die unipolare Dehnungshysterese und **Fig. 5b** den Probenstrom im Temperaturbereich von Raumtemperatur bis 175 °C für das Ausführungsbeispiel 7.

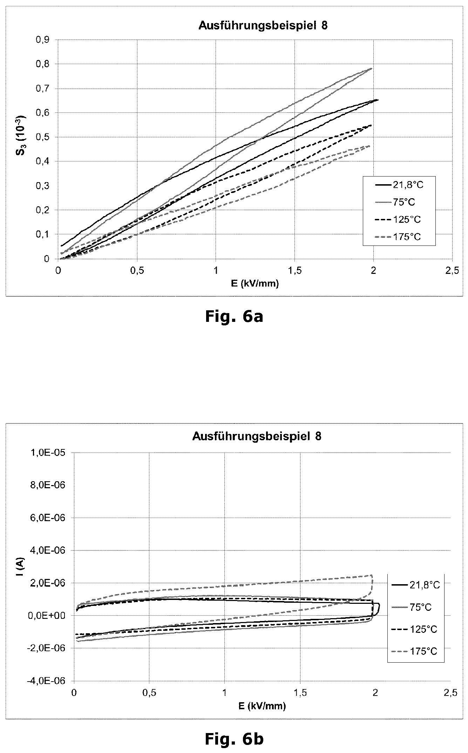

**Fig. 6a** zeigt die unipolare Dehnungshysterese und **Fig. 6b** den Probenstrom im Temperaturbereich von Raumtemperatur bis 175 °C für das Ausführungsbeispiel 8.

## Beispiele

Die im Folgenden angeführten Messergebnisse beziehen sich auf das Grundsystem

$(K_x Na_y Li_{1-x-y})a(Mn_u Ta_v Sb_w Nb_{1-u-v-w})O_3$

Die Mischung der Rohstoffe und die Feinmahlung des Kalzinats erfolgten jeweils in einer Rührwerkskugelmühle.

Pb- und Nb- und optional Mn-Zusätze erfolgten bei folgenden technologischen Schritten:

Bsp. 1-7: Feinmahlung

Bsp. 8: Zusatz bei der Sprühgranulierung

Dabei erfolgte die Pb-und Nb-Zugabe in den Bsp. 2 und 3 als Oxidmischung (M) und in den Bsp. 4, 5 und 8 als vorgebildetes Kalzinat (K). Die Zugabe von Pb, Nb und Mn erfolgte in den Beispielen 6 und 7 als Oxidmischung (M).

In Tabelle 1 sind die für die Bewertung herangezogenen Parameter zusammengefasst.

| Spalte | Parameter |
|---|---|
| 1 | Pb-Zusatz in Gew.-% |
| 2 | Nb-Zusatz in Gew.-% |
| 3 | Zusatz als Oxidmischung (M) oder Kalzinat (K) |
| 4 | Sintertemperatur |
| 5 | Sinterintervall |
| 6 | Dielektrizitätszahl |
| 7 | Dielektrischer Verlustfaktor |
| 8 | Spezifischer Isolationswiderstand (Raumtemperatur) |
| 9 | Spezifischer Isolationswiderstand (150 °C) |
| 10 | Induzierte Dehnung (Raumtemperatur) |
| 11 | Probenstrom (Raumtemperatur) |
| 12 | Messfeldstärke |
| 13 | Maximale Induzierte Dehnung (Raumtemperatur - 150°C) |
| 14 | Temperatur der maximalen Dehnung |
| 15 | Induzierte Dehnung (150 °C) |

Der spezifische Isolationswiderstand $\rho_{is}$ wird bei 50V an gepolten Proben bei Temperaturerhöhung von Raumtemperatur bis 150°C bestimmt.

Die elektromechanische Dehnung $S_3$ wird mittels Laserinterferometer bei 2kV/mm bestimmt. Für Proben, die aufgrund erhöhter Leitfähigkeit nicht bei 2 kV/mm gemessen werden konnten, ist die Messfeldstärke in Spalte 12 angegeben.

Unter Sinterintervall ist der durch zwei Temperaturangaben eingegrenzte Bereich zu verstehen, innerhalb dessen beim Brennen des Werkstoffes die erforderlichen Eigenschaften der Keramik erzielt werden. Diese sind wie folgt definiert:

$$\tan \delta: \quad \leq 50 \cdot 10^{-3}$$
$$S3\ (RT): \quad > 0{,}6 \cdot 10^{-3}$$
$$E_{max}: \quad \geq 2\ kV/mm$$

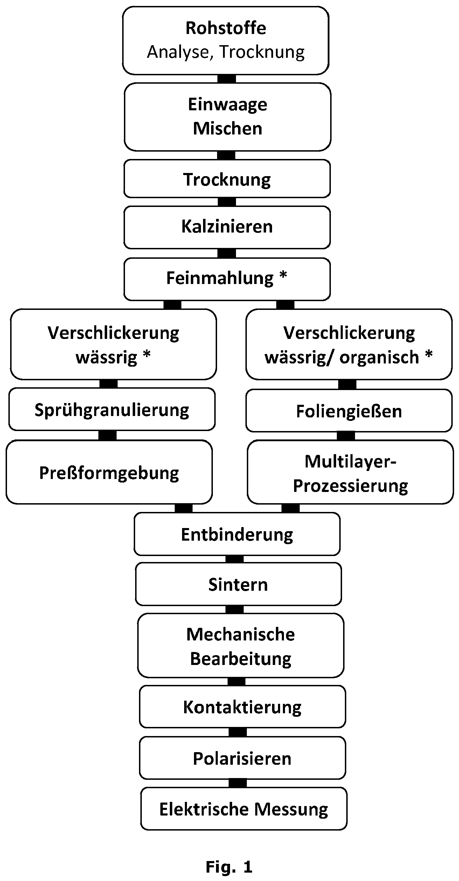

Die nachfolgenden Ausführungsbeispiele zeigen das Verhalten des Standes der Technik (Bsp. 1) und der erfindungsgemäß hergestellten Zusammensetzungen (Bsp. 2 bis 8). Die Proben wurden entsprechend Flussdiagramm (Fig.1) hergestellt.

Die Ergebnisse der Untersuchungen sind in Tabelle 2 dokumentiert.

**Ausführungsbeispiel 1:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

Diese Zusammensetzung entspricht dem Stand der Technik mit einem Sinterintervall ≤20K.

**Ausführungsbeispiel 2:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,1 \text{ Gew.-\% Pb} +0,09 \text{ Gew.-\% Nb,}$$

zugesetzt als Oxidmischung. Diese erfindungsgemäße Zusammensetzung weist eine Verbreiterung des Sinterintervalls auf 30K auf.

**Ausführungsbeispiel 3:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,2 \text{ Gew.-\% Pb} +0,179 \text{ Gew.-\% Nb,}$$

zugesetzt als Oxidmischung. Diese erfindungsgemäße Zusammensetzung weist eine Verbreiterung des Sinterintervalls auf 30K auf.

**Ausführungsbeispiel 4:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,1 \text{ Gew.-\% Pb} +0,09 \text{ Gew.-\% Nb,}$$

zugesetzt als vorgebildetes Kalzinat. Diese erfindungsgemäße Zusammensetzung weist eine Verbreiterung des Sinterintervalls auf 30K auf.

**Ausführungsbeispiel 5:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,2 \text{ Gew.-\% Pb} +0,179 \text{ Gew.-\% Nb,}$$

zugesetzt als vorgebildetes Kalzinat. Diese erfindungsgemäße Zusammensetzung weist eine Verbreiterung des Sinterintervalls auf 30K auf.

**Ausführungsbeispiel 6:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,1 \text{ Gew.-\% Pb} +0,022 \text{ Gew.-\% Nb} +0,013 \text{ Gew.-\% Mn},$$

zugesetzt als Oxidmischung. Diese Zusammensetzung weist keine Verbreiterung des Sinterintervalls auf.

**Ausführungsbeispiel 7:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,1 \text{ Gew.-\% Pb} +0,03 \text{ Gew.-\% Nb} +0,009 \text{ Gew.-\% Mn},$$

zugesetzt als Oxidmischung. Diese Zusammensetzung weist eine Verbreiterung des Sinterintervalls auf 40K auf.

**Ausführungsbeispiel 8:**

Zusammensetzung

$(K_{0,44}Na_{0,52}Li_{0,04})0,998 (Mn_{0,005}[Ta_{0,10}Sb_{0,06}Nb_{0,84}]_{0,995})O_3$

$$+0,1 \text{ Gew.-\% Pb} +0,09 \text{ Gew.-\% Nb},$$

zugesetzt als vorgebildetes Kalzinat. Diese erfindungsgemäße Zusammensetzung weist eine Verbreiterung des Sinterintervalls auf 40K auf. In diesem Ausführungsbeispiel erfolgte durchgängig eine großtechnische Prozessierung des Materials und der Zusatz von Pb und Nb bei der Sprühgranulierung.

Überraschenderweise bleibt der hohe Isolationswiderstand bei erfindungsgemäßer Modifizierung der Zusammensetzung

$(K_{0,44}Na_{0,52}Li_{0,04})0,998 (Mn_{0,005}[Ta_{0,10}Sb_{0,06}Nb_{0,84}]_{0,995})O_3$
durch Pb und Nb und optional Mn erhalten.

Tabelle 2

| Nr. | Zusatz Gew.% Pb | Zusatz Gew.% Nb | | $T_{sint}$ °C | $\Delta T_{sint}$ K | $\varepsilon^T_{33}/\varepsilon_0$ | $\tan\delta$ $10^{-3}$ RT | $\rho_{is}$ $\Omega m$ RT | $\rho_{is}$ $\Omega m$ 150°C | $S_3$ $10^{-3}$ RT | I A RT | bei $E_{max}$ kV/mm | $S_{3,max}$ $10^{-3}$ | $T(S_{3,max})$ °C | $S_3$ $10^{-3}$ 150°C |
|---|---|---|---|---|---|---|---|---|---|---|---|---|---|---|---|
| 1 | 0 | 0,000 | | 1090 | | 1210 | 41,9 | 2,8E+09 | 7,2E+07 | 0,30 | 2,3E-06 | 1,4 | | | |
| 1 | 0 | 0,000 | | 1100 | | 1340 | 40,4 | 1,6E+09 | 5,6E+07 | 0,47 | 2,4E-06 | 2,0 | | | |
| 1 | 0 | 0,000 | | **1110** | | 1300 | 19,6 | 3,5E+10 | 2,6E+08 | 0,78 | 1,7E-06 | 2,0 | 0,86 | 50 | 0,49 |
| 1 | 0 | 0,000 | | **1130** | 20 | 1170 | 26,3 | 2,8E+09 | 2,0E+08 | 0,74 | 2,1E-06 | 2,0 | | | |
| 1 | 0 | 0,000 | | 1140 | | 980 | 57,7 | 4,6E+09 | 3,3E+08 | 0,60 | 2,0E-06 | 1,5 | | | |
| 2 | 0,1 | 0,090 | M | 1100 | | 1390 | 77,1 | | | 0,34 | 2,5E-06 | 1,5 | | | |
| 2 | 0,1 | 0,090 | M | **1110** | | 1330 | 24,1 | 9,9E+09 | 1,3E+08 | 0,74 | 1,6E-06 | 2,0 | | | |
| 2 | 0,1 | 0,090 | M | **1130** | | 1270 | 36,2 | | | 0,72 | 1,6E-06 | 2,0 | | | |
| 2 | 0,1 | 0,090 | M | **1140** | 30 | 1180 | 46,2 | 4,0E+09 | 7,8E+07 | 0,67 | 2,9E-06 | 2,0 | | | |
| 2 | 0,1 | 0,090 | M | 1150 | | 1220 | 206,2 | | | | | | | | |
| 3 | 0,2 | 0,179 | M | 1100 | | 1420 | 57,4 | | | 0,53 | 2,5E-06 | 2,0 | | | |
| 3 | 0,2 | 0,179 | M | **1110** | | 1620 | 20,1 | | | 0,75 | 1,8E-06 | 2,0 | | | |
| 3 | 0,2 | 0,179 | M | **1130** | | 1350 | 24,8 | 2,3E+10 | 2,3E+08 | 0,75 | 1,6E-06 | 2,0 | 0,83 | 50 | 0,48 |
| 3 | 0,2 | 0,179 | M | **1140** | 30 | 1350 | 32,3 | | | 0,74 | 1,5E-06 | 2,0 | | | |
| 3 | 0,2 | 0,179 | M | 1150 | | 1220 | 61,6 | | | 0,46 | 6,5E-05 | 1,5 | | | |
| 4 | 0,1 | 0,090 | K | 1100 | | 1380 | 75,9 | | | 0,39 | 2,7E-06 | 1,5 | | | |
| 4 | 0,1 | 0,090 | K | **1110** | | 1420 | 24,0 | | | 0,76 | 1,7E-06 | 2,0 | | | |
| 4 | 0,1 | 0,090 | K | **1130** | | 1350 | 24,7 | 1,9E+10 | 1,5E+08 | 0,76 | 1,6E-06 | 2,0 | | | |
| 4 | 0,1 | 0,090 | K | **1140** | 30 | 1240 | 42,7 | | | 0,66 | 2,0E-05 | 2,0 | | | |
| 4 | 0,1 | 0,090 | K | 1150 | | 1290 | 186,1 | | | | | | | | |
| 5 | 0,2 | 0,179 | K | 1100 | | 1420 | 55,1 | | | 0,55 | 2,6E-06 | 2,0 | | | |
| 5 | 0,2 | 0,179 | K | **1110** | | 1450 | 19,5 | | | 0,79 | 1,7E-06 | 2,0 | | | |
| 5 | 0,2 | 0,179 | K | **1130** | | 1300 | 35,5 | 2,0E+10 | 1,6E+08 | 0,69 | 1,7E-06 | 2,0 | 0,81 | 50 | 0,49 |

(fortgesetzt)

| Nr. | Zusatz | | | $T_{sint}$ | $\Delta T_{sint}$ | $\varepsilon^T{}_{33}/\varepsilon_0$ | $\tan\delta$ | $\rho_{is}$ | $\rho_{is}$ | $S_3$ | I | bei $E_{max}$ | $S_{3,max}$ | $T(S_{3,max})$ | $S_3$ |
|---|---|---|---|---|---|---|---|---|---|---|---|---|---|---|---|
| | Gew.% | Gew.% | | °C | K | | $10^{-3}$ | $\Omega m$ | $\Omega m$ | $10^{-3}$ | A | kV/mm | $10^{-3}$ | °C | $10^{-3}$ |
| | Pb | Nb | | | | | RT | RT | RT | 150°C | RT | RT | | | | 150°C |
| 5 | 0,2 | 0,179 | K | **1140** | 30 | 1410 | 31,2 | | | 0,72 | 1,5E-06 | 2,0 | | | |
| 5 | 0,2 | 0,179 | K | 1150 | | 1190 | 64,6 | | | 0,45 | 4,6E-05 | 1,5 | | | |
| 6 | 0,1 | 0,022 | M | 1090 | | 1480 | 31,9 | 1,7E+09 | 5,7E+07 | 0,57 | 1,9E-06 | 2,0 | | | |
| 6 | 0,1 | 0,022 | M | **1110** | | 1420 | 22,4 | 2,1E+10 | 2,0E+08 | 0,74 | 1,5E-06 | 2,0 | 0,82 | 50 | 0,50 |
| 6 | 0,1 | 0,022 | M | **1130** | 20 | 1310 | 25,6 | 5,6E+09 | 6,4E+07 | 0,72 | 2,1E-06 | 2,0 | | | |
| 6 | 0,1 | 0,022 | M | 1140 | | 1080 | 143,0 | 8,2E+08 | 5,8E+06 | | | | | | |
| 7 | 0,1 | 0,030 | M | **1090** | | 1440 | 32,5 | | | 0,61 | 2,0E-06 | 2,0 | | | |
| 7 | 0,1 | 0,030 | M | **1100** | | 1580 | 27,4 | 5,8E+09 | 1,5E+08 | 0,82 | 2,0E-06 | 2,0 | | | |
| 7 | 0,1 | 0,030 | M | **1110** | | 1570 | 22,0 | 3,7E+10 | 1,9E+08 | 0,73 | 1,7E-06 | 2,0 | 0,75 | 60 | 0,50 |
| 7 | 0,1 | 0,030 | M | **1130** | 40 | 1340 | 21,5 | 1,1E+10 | 1,2E+08 | 0,73 | 1,9E-06 | 2,0 | | | |
| 7 | 0,1 | 0,030 | M | 1140 | | 1040 | 138,0 | 6,9E+08 | 7,3E+06 | | | | | | |
| 8 | 0,1 | 0,090 | K | 1070 | | 1090 | 29,5 | 6,3E+08 | 1,7E+08 | 0,52 | 1,6E-06 | 2,0 | 0,62 | 60 | 0,41 |
| 8 | 0,1 | 0,090 | K | **1080** | | 1160 | 30,3 | 2,3E+09 | 1,3E+08 | 0,62 | 1,0E-06 | 2,0 | 0,64 | 40 | 0,49 |
| 8 | 0,1 | 0,090 | K | **1090** | | 1120 | 29,3 | 3,2E+09 | 1,8E+08 | 0,65 | 1,1E-06 | 2,0 | 0,69 | 50 | 0,49 |
| 8 | 0,1 | 0,090 | K | **1100** | | 1070 | 30,1 | 2,7E+09 | 2,8E+08 | 0,61 | 1,2E-06 | 2,0 | 0,82 | 50 | 0,50 |
| 8 | 0,1 | 0,090 | K | **1110** | | 1010 | 26,9 | 2,7E+09 | 1,0E+09 | 0,62 | 1,2E-06 | 2,0 | 0,78 | 60 | 0,48 |
| 8 | 0,1 | 0,090 | K | **1120** | 40 | 990 | 29,4 | 8,7E+08 | 4,7E+08 | 0,65 | 1,1E-06 | 2,0 | 0,87 | 60 | 0,48 |

**Patentansprüche**

1. Piezokeramischer Werkstoff mit reduziertem Bleigehalt auf Kalium-Natrium-Niobat (KNN)-Basis der Grundzusammensetzung
$(K_xNa_yLi_{1-x-y})a (Mn_uTa_vSb_wNb_{1-u-v-w})O_3$ mit
$0<x<1$ y; $0<y<1$; $0<u<0,01$; $0<v<0,3$; $0\leq w<0,2$ und
$0,95<a<1,05$; $x+y \leq 1$;
**gekennzeichnet durch**
die Zugabe einer Mischung von Pb, Nb und optional Ag gemäß k Gew.-% Pb + I Gew.-% Nb + m Gew.-% Ag mit
$0<k<0,5$; $0<l<1$; $0\leq m<1$.

2. Piezokeramischer Werkstoff gemäß Anspruch 1, **dadurch gekennzeichnet, dass** $0,001<k\leq0,2$ ist.

3. Piezokeramischer Werkstoff gemäß einem der Ansprüche 1 oder 2, **dadurch gekennzeichnet, dass** $0<l\leq0,179$ ist.

4. Piezokeramischer Werkstoff nach mindestens einem der vorhergehenden Ansprüche, **dadurch gekennzeichnet, dass** $0,001<k\leq0,2$ ist und $0<l<0,179$ ist.

5. Piezokeramischer Werkstoff nach mindestens einem der vorhergehenden Ansprüche, **dadurch gekennzeichnet, dass** $0,001<k\leq0,1$ ist.

6. Piezokeramischer Werkstoff nach mindestens einem der vorhergehenden Ansprüche, **dadurch gekennzeichnet, dass** $0,022<l\leq0,09$ ist.

7. Piezokeramischer Werkstoff nach mindestens einem der vorhergehenden Ansprüche, **dadurch gekennzeichnet, dass** $0,001<k\leq01$ ist und $0,022<l\leq0,09$ ist.

8. Piezokeramischer Werkstoff nach mindestens einem der vorhergehenden Ansprüche, **dadurch gekennzeichnet, dass** das Verhältnis von k:l im Bereich von 1:0,9 bis 1:0,3 liegt.

9. Piezokeramischer Werkstoff nach mindestens einem der vorhergehenden Ansprüche, **gekennzeichnet durch** die Zugabe einer Mischung von k Gew.-% Pb, Gew.-% Nb und n Gew.-% Mn, wobei das Verhältnis n:l im Bereich von 0,05 bis 0,15:0,30 liegt.

10. Piezokeramischer Werkstoff gemäß Anspruch 9, **dadurch gekennzeichnet, dass** das Verhältnis k:n:l bei 1:0,09:0,30 liegt.

11. Verfahren zur Herstellung eines piezokeramischen Werkstoffs mit reduziertem Bleigehalt nach einem der vorhergehenden Ansprüche, **gekennzeichnet durch** folgende Schritte:

    - Herstellung einer Rohstoffmischung der Grundzusammensetzung
    - Herstellung eines Kalzinats der Grundzusammensetzung
    - Feinmahlung des Kalzinats
    - Herstellung eines Granulats insbesondere durch Sprühgranulierung oder Herstellung eines Gießschlickers für den Multilayer- oder "Co-firing"-Prozess
    - Weiterverarbeitung in bekannter Weise einschließlich Sinterung in normaler Atmosphäre.

12. Piezokeramischer Multilayeraktor auf Basis eines piezokeramischen Werkstoffes nach einem der Ansprüche 1 bis 10.

13. Verwendung einer Mischung von Pb, Nb und optional Ag in einem piezokeramischen Werkstoff auf Kalium-Natrium-Niobat (KNN)-Basis der Grundzusammensetzung
$(K_xNa_yLi_{1-x-y})a (Mn_uTa_vSb_wNb_{1-u-v-w})O_3$ mit
$0<x<1$ y; $0<y<1$; $0<u<0,01$; $0<v<0,3$; $0\leq w<0,2$ und
$0,95<a<1,05$; $x+y \leq 1$;
zur Erhöhung des Sinterintervalls des piezokeramischen Werkstoffs, wobei die Zugabe einer Mischung von Pb und Nb so erfolgt, dass der Gehalt von durch die Zugabe zugesetztem Pb, Nb und Ag in Gew.-% bezogen auf den gesamten piezokeramischen Werkstoff wie folgt ist:

$$k \text{ Gew.-\% Pb} + l \text{ Gew.-\% Nb} + m \text{ Gew.-\% Ag}$$

mit

$0<k<0{,}5$; $0<l<1$; $0\leq m\leq 1$, wobei unter Sinterintervall der durch zwei Temperaturangaben eingegrenzte Bereich zu verstehen ist, innerhalb dessen beim Brennen des Werkstoffes die erforderlichen Eigenschaften der Keramik erzielt werden, die wie folgt definiert sind:

| | |
|---|---|
| $\tan \delta$: | $\leq 50 \cdot 10^{-3}$ |
| S3 (RT): | $>0{,}6 \cdot 10^{-3}$ |
| $E_{max}$: | $\geq 2$ kV/mm. |

14. Verwendung nach Anspruch 13, **dadurch gekennzeichnet, dass** $0{,}001<k\leq 0{,}2$ ist und $0<l\leq 0{,}179$ ist.

15. Verwendung nach Anspruch 13 oder 14, **dadurch gekennzeichnet, dass** $0{,}001<k\leq 0{,}1$ ist und $0{,}022<l\leq 0{,}09$ ist.

16. Verwendung nach Anspruch 14 oder 15, **dadurch gekennzeichnet, dass** das Verhältnis von k:l im Bereich von 1:0,9 bis 1:0,3 liegt.

17. Verwendung nach Anspruch 15 oder 16, **gekennzeichnet t durch** die Zugabe einer Mischung von k Gew.-% Pb, l Gew.-% Nb und n Gew.-% Mn, wobei das Verhältnis n:l im Bereich von 0,05 bis 0,15:0,30 liegt.

18. Verwendung nach Anspruch 17, **dadurch gekennzeichnet, dass** das das Verhältnis k:n:l bei 1:0,09:0,30 liegt.

**Claims**

1. A piezoceramic material with reduced lead content, based on potassium sodium niobate (PSN) of the basic composition
   $(K_xNa_yLi_{1-x-y})a (Mn_uTa_vSb_wNb_{1-u-v-w})O_3$, with
   $0<x<1$ y; $0<y<1$; $0<u<0.01$; $0<v<0.3$; $0\leq w<0.2$ and
   $0.95<a<1.05$; $x+y \leq 1$;
   **characterized by**
   the addition of a mixture of Pb, Nb and optionally Ag according to k% by weight Pb + l% by weight Nb + m% by weight Ag with
   $0<k<0.5$; $0<l<1$; $0\leq m<1$.

2. A piezoceramic material according to claim 1, **characterized in that** $0.001 <k\leq 0.2$.

3. A piezoceramic material according to one of the claims 1 or 2, **characterized in that** $0<l\leq 0.179$.

4. A piezoceramic material according to at least one of the preceding claims, **characterized in that** $0.001<k\leq 0.2$ and $0<l\leq 0.179$.

5. A piezoceramic material according to at least one of the preceding claims, **characterized in that** $0.001<k\leq 0.1$.

6. A piezoceramic material according to at least one of the preceding claims, **characterized in that** $0.022<l\leq 0.09$.

7. A piezoceramic material according to at least one of the preceding claims, **characterized in that** $0.001<k\leq 0.1$ and $0.022<l\leq 0.09$.

8. A piezoceramic material according to at least one of the preceding claims, **characterized in that** the ratio of k:l lies in the range of 1:0.9 to 1:0.3.

9. A piezoceramic material according to at least one of the preceding claims, **characterized by** the addition of a mixture of k% by weight Pb, l% by weight Nb, and n% by weight Mn, wherein the ratio of n:l lies in the range of 0.05 to 0.15:0.30.

10. A piezoceramic material according to claim 9, **characterized in that** the ratio of k:n:l lies at 1:0.09:0.30.

11. A method for producing a piezoceramic material with reduced lead content according to one of the preceding claims, **characterized by** the following steps:

- producing a raw material mixture of the basic composition;
- producing a calcinate of the basic composition;
- fine grinding of the calcinate;
- producing a granulate, especially by spray granulation, or producing a casting slurry for the multilayer or "co-firing" process;
- further processing in the known manner, including sintering in normal atmosphere.

12. A piezoceramic multilayer actuator on the basis of a piezoceramic material according to one of the claims 1 to 10.

13. The use of a mixture of Pb, Nb and optionally Ag in a piezoceramic material, based on potassium sodium niobate (PSN) of the basic composition
$(K_xNa_yLi_{1-x-y})a (Mn_uTa_vSb_wNb_{1-u-v-w})O_3$, with
$0 < x < 1$ y; $0 < y < 1$; $0 < u < 0.01$; $0 < v < 0.3$; $0 \leq w < 0.2$ and
$0.95 < a < 1.05$; $x+y \leq 1$;
for increasing the sintering interval of the piezoceramic material, wherein the addition of a mixture of Pb and Nb occurs in such a way that the content of added Pb, Nb and Ag in percent by weight relating to the entire piezoceramic material is as follows:

$$k\% \text{ by weight Pb} + l\% \text{ by weight Nb} + m\% \text{ by weight Ag,}$$

with
$0 < k < 0.5$; $0 < l < 1$; $0 \leq m < 1$, wherein the range bounded by two temperature specifications is to be understood as the sintering interval, within which the required properties of the ceramic material are achieved during the burning of the material, which are defined as follows:

| | |
|---|---|
| $\tan \delta$: | $\leq 50 \ 10^{-3}$ |
| S3 (RT): | $> 0.6 \ 10^{-3}$ |
| $E_{max}$: | $\geq 2$ kV/mm |

14. The use according to claim 13, **characterized in that** $0.001 < k \leq 0.2$ and $0 < l \leq 0.179$.

15. The use according to claim 13 or 14, **characterized in that** $0.001 < k \leq 0.1$ and $0.022 < l \leq 0.09$.

16. The use according to claim 14 or 15, **characterized in that** the ratio of k:l lies in the range of 1:0.9 to 1:0.3.

17. The use according to claim 15 or 16, **characterized by** the addition of a mixture of k% by weight Pb, l% by weight Nb, and n% by weight Mn, wherein the ratio of n:l lies in the range of 0.05 to 0.15:0.30.

18. The use according to claim 17, **characterized in that** the ratio of k:n:l lies at 1:0.09:0.30.

**Revendications**

1. Matière piézocéramique à teneur en plomb réduite à base de potassium-sodium-niobate (KNN) ayant la composition élémentaire $(K_xNa_yLi_{1-x-y})a (Mn_uTa_vSb_wNb_{1-u-v-w})O_3$ avec
$0 < x < 1$ y ; $0 < y < 1$ ; $0 < u < 0,01$ ; $0 < v < 0,3$ ; $0 \leq w < 0,2$ et
$0,95 < a < 1,05$ ; $x + y < 1$ ;

**caractérisée par**

l'ajout d'un mélange de Pb, Nb et optionnellement d'Ag selon k % en poids de Pb + l % en poids de Nb + m % en poids d'Ag

avec

$0 < k < 0,5$ ; $0 < l < 1$ ; $0 \leq m < 1$.

2. Matière piézocéramique selon la revendication 1,
   **caractérisée en ce que**
   $0,001 < k \leq 0,2$.

3. Matière piézocéramique selon l'une des revendications 1 ou 2,
   **caractérisée en ce que**
   $0 < l \leq 0,179$.

4. Matière piézocéramique selon l'une au moins des revendications précédentes,
   **caractérisée en ce que**
   $0,001 < k \leq 0,2$ et $0 < l < 0,179$.

5. Matière piézocéramique selon l'une au moins des revendications précédentes,

   **caractérisée en ce que**
   $0,001 < k \leq 0,1$.

6. Matière piézocéramique selon l'une au moins des revendications précédentes,
   **caractérisée en ce que**
   $0,022 < l \leq 0,09$.

7. Matière piézocéramique selon l'une au moins des revendications précédentes,
   **caractérisée en ce que**
   $0,001 < k \leq 0,1$ et $0,022 < l \leq 0,09$.

8. Matière piézocéramique selon l'une au moins des revendications précédentes,
   **caractérisée en ce que**
   le rapport de k:l est dans la plage de 1:0,9 à 1:0,3.

9. Matière piézocéramique selon l'une au moins des revendications précédentes,
   **caractérisée par**
   l'ajout d'un mélange de k % en poids de Pb + l % en poids de Nb + n % en poids de Mn,
   dans lequel le rapport de n:l est dans la plage de 0,05 à 0,15:0,30.

10. Matière piézocéramique selon la revendication 9,
    **caractérisée en ce que**
    le rapport de k:n:l est de l'ordre de 1:0,09:0,30.

11. Procédé de réalisation d'une matière piézocéramique à teneur en plomb réduite selon l'une des revendications précédentes, **caractérisé par** les étapes suivantes :

    - on réalise un mélange de matière brute de la composition élémentaire,
    - on réalise un produit de calcination,
    - on broie finement le produit de calcination,
    - on réalise un granulé en particulier par granulation par pulvérisation, ou on réalise une barbotine de coulée pour le processus dit multicouche ou "co-cuisson" (co-firing),
    - on continue le traitement de façon connue, y compris le frittage sous atmosphère normale.

12. Actionneur multicouche piézocéramique à base d'une matière piézocéramique selon l'une des revendications 1 à 10.

13. Utilisation d'un mélange de Pb, Nb et optionnellement d'Ag dans une matière piézocéramique à base de potassium-sodium-niobate (KNN) ayant la composition élémentaire

$(K_xNa_yLi_{1-x-y})a (Mn_uTa_vSb_wNb_{1-u-v-w})O_3$ avec
$0 < x < 1$ y ; $0 < y < 1$ ; $0 < u < 0,01$ ; $0 < v < 0,3$ ; $0 \leq w < 0,2$ et
$0,95 < a < 1,05$ ; $x + y \leq 1$ ;
pour augmenter l'intervalle de frittage de la matière piézocéramique, dans laquelle
l'ajout d'un mélange de Pb et de Nb s'effectue de telle sorte que la teneur en Pb, Nb et Ag apportés par l'ajout est, en % en poids par rapport à la totalité de la matière piézocéramique, comme suit :

k % en poids Pb + l % en poids de Nb + m % en poids d'Ag
avec
$0 < k < 0,5$ ; $0 < l < 1$ ; $0 \leq m < 1$.
et dans laquelle
on entend par intervalle de frittage la plage limitée par deux indications de température, à l'intérieur de laquelle on obtient les propriétés nécessaires de la céramique pendant l'incinération de la matière, qui sont définies comme suit :

| | |
|---|---|
| tan $\delta$ : | $\leq 50 \cdot 10^{-3}$ |
| S3 (RT) : | $> 0,6 \cdot 10^{-3}$ |
| Emax : | $\geq 2$ kV/mm |

**14.** Utilisation selon la revendication 13,
**caractérisée en ce que**
$0,001 < k \leq 0,2$ et $0 < l \leq 0,179$.

**15.** Utilisation selon la revendication 13 ou 14,
**caractérisée en ce que**
$0,001 < k \leq 0,1$ et $0,022 < l \leq 0,09$.

**16.** Utilisation selon la revendication 14 ou 15,
**caractérisée en ce que**
le rapport de k:l est dans la plage de 1:0,9 à 1:0,3.

**17.** Utilisation selon la revendication 15 ou 16,
**caractérisée par**
l'ajout d'un mélange de k % en poids de Pb + l % en poids de Nb + n % en poids de Mn,
dans lequel le rapport de n:l est dans la plage de 0,05 à 0,15:0,30.

**18.** Utilisation selon la revendication 17,
**caractérisée en ce que**
le rapport de k:n:l est de l'ordre de 1:0,09:0,30.

**Fig. 1**

**Fig. 2**

**Fig. 3**

Fig. 4a

Fig. 4b

**Fig. 5a**

**Fig. 5b**

**Fig. 6a**

**Fig. 6b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1382588 A1
- DE 102007013874 A1
- EP 2104152 A2
- EP 1876155 A1
- EP 1876156 A1
- DE 112006003755 B4
- EP 1702906 A1
- DE 10234787 C1

**In der Beschreibung aufgeführte Nicht-Patentliteratur**

- **SAITO U.A.** Lead-free piezoceramics. *Letters to Nature,* 2004
- **LI U.A.** *J. Am. Ceram. Soc.,* 2013, vol. 96 (12), 3677-3696
- **PANG U.A.** *Ceramics International,* 2012, vol. 38, 2521-2527